(19) **Europäisches Patentamt**

**European Patent Office**

**Office européen des brevets**

(11) **EP 1 627 694 A1**

(12) **EUROPEAN PATENT APPLICATION**
published in accordance with Art. 158(3) EPC

(43) Date of publication:
**22.02.2006 Bulletin 2006/08**

(51) Int Cl.:
*B09B 3/00* (1980.01)  *C01B 33/18* (1968.09)
*C08K 3/36* (1990.01)  *C08L 101/00* (1985.01)
*H01L 23/29* (1990.01)

(21) Application number: **04719601.9**

(22) Date of filing: **11.03.2004**

(86) International application number:
**PCT/JP2004/003175**

(87) International publication number:
**WO 2004/098803 (18.11.2004 Gazette 2004/47)**

(84) Designated Contracting States:
**AT BE BG CH CY CZ DE DK EE ES FI FR GB GR
HU IE IT LI LU MC NL PL PT RO SE SI SK TR**

(30) Priority: **08.05.2003 JP 2003130367**

(71) Applicant: **NITTO DENKO CORPORATION
Ibaraki-shi,
Osaka 567-8680 (JP)**

(72) Inventors:
• **KUROYANAGI, Akihisa,
Nitto Denko Corporation
Ibaraki-shi, Osaka 567-8680 (JP)**
• **NISHIMORI, Shuji,
Shikoku Research Institute Inc.
Takamatsu-shi,
Kagawa 761-019 (JP)**
• **YAMAJI, Tsuyoshi,
Shikoku Research Institute Inc.
Takamatsu-shi,
Kagawa 761-0192 (JP)**

(74) Representative: **Grünecker, Kinkeldey,
Stockmair & Schwanhäusser
Anwaltssozietät
Maximilianstrasse 58
80538 München (DE)**

(54) **FLY ASH POWDER, METHOD FOR PRODUCING THE SAME, AND RESIN COMPOSITION FOR SEALING SEMICONDUCTOR USING THE SAME, AND SEMICONDUCTOR DEVICE**

(57) A fly ash powder containing substantially no silanol group, wherein electric conductivity of water extract after soaking of 10 g of the fly ash powder in 100 ml of a pure water at 20°C for 6 hours is 200 µS/cm or less. A fly ash powder in which the ionic impurity content is reduced and is excellent in affinity (wettability) for various resins is provided.

EP 1 627 694 A1

**Description**

<Technical Field>

The present invention relates to a fly ash powder having excellent wettability (affinity) for resins effected by the washing and elimination of ionic impurities and a production method thereof, as well as to a resin composition for semiconductor encapsulation which uses the same and further to a semiconductor device using the same.

<Background of the Invention>

As represented by compression molding, extrusion molding and injection molding, plastic products which are used in various applications are produced by once making a resin composition into a state of having fluidity by heating or the like and then forming it into a desired shape in a predetermined mold. Aiming at certain mechanical characteristics, increase in quality and the like, an inorganic filler represented by by silica, calcium carbonate, talc or the like is conventionally added to the aforementioned resin composition.

Particularly, in the case of a material for semiconductor encapsulation which encapsulates a semiconductor with a resin, a fused silica is conventionally used as the inorganic filler, because its coefficient of thermal expansion is small, it has electrical insulation property and its dielectric loss is small even at the high frequency range. Among such fused silica, fused silica of a crashed state was previously used, but recently, high density filling property of inorganic fillers is required from the viewpoint of the solder resistance, heat cycle resistance and the like due to changes in the packaging form accompanying the higher integration of semiconductors. In the conventional materials for semiconductor encapsulation, the blending amount of the inorganic filler was approximately 70% by weight based on the total, but in the recent applications which require high density filling property, the blending amount is set to 90% by weight or more in some cases.

However, when a material for semiconductor encapsulation is prepared using the conventional fused silica of a crashed state or the like alone and blending it at a high ratio of 90% by weight or more, it causes a problem that the resin viscosity at the time of molding becomes considerably high and, as a result, un-filling, void, wire flow and the like frequently occur in the packages, which substantially unable to carry out the molding. Accordingly, spherical inorganic filler such as a spherical fused silica or the like is used in the application of the material for semiconductor encapsulation which requires high density filling property. Recently, spherical inorganic fillers are used also in the general field of materials for semiconductor encapsulation and other fields of plastic molding materials.

The spherical fused silica prepared by spheroidizing crystal silica of a crashed state with a thermal spraying method may be exemplified as such a spherical inorganic filler which is practically easily available. However, it has a disadvantage of being expensive, so that there is a demand for an inorganic filler which corresponds to the spherical fused silica and can be provided inexpensively and in a large amount. Also, since the crystal silica of a crashed state is crushed and subjected to thermal straying in the spherical fused silica of the aforementioned thermal spraying method, its particle diameter is determined by the crushing grain size, so that an average particle diameter of 5 $\mu$m is substantially the limit. Accordingly, it is the present situation that the spherical silica having a particle diameter of less than 5 $\mu$m necessary for high density filling is prepared by collecting a small amount of fine powder captured by the back filter at the production step of thermal spraying method or by obtaining a spherical silica by an extremely expensive synthesis method. Thus, since a conventional spherical silica fine powder having a particle diameter of approximately from 5 to 8 $\mu$m is expensive due to its low supplying amount and difficulty in synthesis, and a spherical silica ultra fine powder having a particle diameter of less than 5 $\mu$m is extremely expensive, an inorganic filler as an inexpensive spherical fine powder has been in demand.

On the other hand, the fly ash discharged in a large amount from coal combustion power plants is a spherical matter, and it is known that its fluidity is improved when used as a molding material, such as improvement of fluidity of concrete when it is blended as a concrete mixture. In addition, since the aforementioned fly ash is a by-product component, it is quite economical and excellent in affinity with resins and has hardness and coefficient of thermal expansion which are equivalent to those of the spherical fused silica, so that it almost satisfies the aforementioned requirements. Since fly ashes of the aforementioned fine powder and ultra fine powder regions are produced in a large amount as fraction fly ashes by various classifiers, it is evident that it is superior also from the economy point of view.

However, ionic impurities in a large amount are present on the fly ash surface and it has poor affinity with resins. When it is used as an inorganic filler for plastics use, it causes problems such as its aggregation due to irregular dispersion in a resin as the matrix component, so that it was difficult to apply it to practical use in various fields such as materials for semiconductor encapsulation and the like. For the purpose of solving such problems, a method has been proposed in which the amount of alkali metal ions as impurities is reduced by baking fly ash at a high temperature and then washing it with a mineral acid aqueous solution (cf. Patent Reference 1).

Reference 1: JP-A-11-199218

<Disclosure of the Invention>

However, the aforementioned silica powder in the form of fine powder obtained by taking into consideration of only the reduction of the amount of alkali metal ions is not sufficient enough regarding its affinity (wettability) with various resins, and is insufficient as various applications, for example, as the application of the aforementioned material for semiconductor encapsulation in which demand for its reliability has been further increased in recent years.

The present invention has been made by taking such situations into consideration, and an object thereof is to provide a fly ash powder having reduced ionic impurity content and excellent affinity (wettability) for various resins, a production method thereof, a resin composition for semiconductor encapsulation which uses the same, and a semiconductor device.

For the purpose of achieving the aforementioned object, a first gist of the present invention resides in a fly ash powder which contains substantially no silanol group, wherein electric conductivity of water extract after soaking of 10 g of the fly ash powder in 100 ml of pure water at 20°C for 6 hours is 200 μS/cm or less. Also, its second gist resides in a method for producing a fly ash powder, which is a method for producing the aforementioned fly ash powder, wherein a fly ash powder material is baked at a temperature of from 500 to 900°C, and then the aforementioned fly ash powder material after baking is washed using an acidic aqueous solution having an acid concentration of 1.0 mol/l or less, subsequently washed using pure water, dried and then pulverized. Also, its third gist resides in a method for producing a fly ash powder, which is a method for producing the aforementioned fly ash powder, wherein a fly ash powder material is baked at a temperature of from 500 to 900°C, and then the aforementioned fly ash powder material after baking is washed using an acidic aqueous solution having an acid concentration of 15.0 mol/l or more, subsequently washed using pure water, dried, pulverized and then again baked at a temperature of from 500 to 900°C. Also, its fourth gist resides in a resin composition for semiconductor encapsulation, which comprises the aforementioned fly ash powder as an inorganic filler, and its fifth gist resides in a semiconductor device comprising a semiconductor element having been encapsulated by the aforementioned resin composition for semiconductor encapsulation.

By taking note of effective utilization of fly ash as a by-product material, the present inventors have solved the problems involved in its use. That is, a series of studies were carried out in order to obtain a fly ash powder from which ionic impurities are removed and which is excellent in affinity (wettability) for resins and suited for practical use. As a result, it was ascertained that a fly ash powder which does not substantially contain silanol group, wherein electric conductivity of water extract after soaking of 10 g of the fly ash powder in 100 ml of pure water at 20°C for 6 hours is set to 200 μS/cm or less, has excellent affinity (wettability) for resins and is suited for practical use as an inorganic filler in various applications. Thereafter, the present invention was accomplished by finding that such a fly ash powder can be obtained by baking a fly ash powder material at a temperature of from 500 to 900°C, and then washing the aforementioned fly ash powder material after baking using an acidic aqueous solution, subsequently washing it using pure water, drying it and pulverizing it, and then again baking it at a temperature of from 500 to 900°C depending on the acid concentration of the aforementioned acidic aqueous solution.

<Best Mode for Carrying Out the Invention>

Next, embodiments of the present invention are described in detail.

The fly ash powder of the present invention is a purified powder prepared by washing and removing ionic impurities, which contains substantially no silanol group shown by the following formula (1), wherein electric conductivity of water extract after soaking of 10 g of the fly ash powder in 100 ml of pure water at 20°C for 6 hours is 200 μS/cm or less. Particularly preferably, it contains substantially no silanol group shown by the following formula (1), wherein electric conductivity of water extract after soaking of 10 g of the fly ash powder in 100 ml of pure water at 160°C for 24 hours is 50 μS/cm or less.

$$\equiv Si-OH \quad \cdots \cdots \quad (1)$$

In this connection, the aforementioned term "contains(s) substantially no silanol group" according to the present invention means that ratio of the silanol group content is 0.10 or less, more preferably 0.090 or less, particularly preferably 0.040 or less, as a result of chemically modifying silanol group on the surface of the fly ash powder with tridecafluoro-1,1,2,2-tetrahydrooctyl-1-trichlorosilane (to be referred to as TDFS hereinafter) and then determining its amount by carrying out X-ray photoelectron spectroscopy analysis (ESCA analysis). This is illustratively described in the following. That is, 1 g of fly ash powder is diluted with 95% ethanol containing 10% TDFS to be used as a fluorine system coupling agent, salting out is repeated, and Soxhlet extraction is carried out for 100 hours or more to remove unreacted TDFS. After its washing, the sample powder is dried at 110°C to obtain a sample in which silanol group is chemically modified.

This sample powder is fixed to a conductive pressure sensitive adhesive tape to carry out ESCA analysis.

In this connection, the device to be used in the aforementioned ESCA analysis and measuring conditions are as follows. That is, Shimadzu/Kratos AXIS-His of Shimadzu Corp. is used as the analyzing and measuring device, A1 K$\alpha$ (using a monochromator) is used as the X-ray source, and the X-ray output is set to 150 W (15 kV). The photoelectron ejection angle is set to 90° against the sample surface, and the analyzing area is set to 300 x 700 $\mu$m. Also, the binding energy is shifted and corrected based on the C1s peak top as 285.0 eV. Thereafter, amount of the silanol group by chemical modification method is determined by calculating the ratio of silanol group to total Si [Si-OH]/[Si] = ([F1s]/13)/{[Si2p] - ([F1s]/13)}. In the above formula, [F1s] and [Si2p] are F and Si atom (atomic) % respectively obtained from F1s and Si2p signals. As a result of the calculation, the term "does not substantially contain silanol group" according to the present invention indicates that the ratio of [Si-OH]/[Si], namely ratio of the silanol group content becomes 0.10 or less, more preferably 0.090 or less, particularly preferably 0.040 or less.

The fly ash to be used as the material of the fly ash powder production method of the present invention is particles of fine ash in the flue gas, and generally has a shape close to spherical. As ionic impurities, for example, ammonium ion, sulfate ion, calcium ion, sodium ion, magnesium ion, chlorine ion and the like are contained in a large amount in the fly ash which underwent partially imperfect burning in a so-called coal combustion power plant and passed through an NO$_x$ removal system and an electric dust collector. Though the amounts of these ionic impurities vary depending on the carbon species. As an example, the electric conductivity of water extract after extraction of ionic impurities in fly ash by soaking of 10 g of an unwashed fraction fly ash having an average particle diameter of 6 $\mu$m in 100 ml of ultra-pure water at 20°C for 6 hours is an extremely high value of about 1000 $\mu$S/cm, wherein about 500 ppm of ammonium ion, about 500 ppm of sulfate ion, about 200 ppm of calcium ion and about 20 ppm of sodium ion are detected, and pH of the extract is about 10.

In addition, for example, when a material for semiconductor encapsulation was produced using the aforementioned unwashed fraction fly ash having an average particle diameter of 6 $\mu$m instead of the current fused silica generally used in materials for semiconductor encapsulation and then a hardened product is obtained by hardening this material, the hardened product was subjected to sufficient post-hardening and pulverizzation, 10 g of pulverized matter of the hardened product was soaked in 100 ml of ultra-pure water, and then ionic impurities in the fly ash were extracted in the ultra-pure water for 24 hours under a high temperature high pressure condition of 160°C; electric conductivity of the water extract at 20°C was 440 $\mu$S/cm, showing about 10 times larger value in comparison with the case of the aforementioned current fused silica, and particularly, the sulfate ion concentration was 1360 ppm which is about 100 times higher concentration in comparision with the case of the aforementioned current fused silica. Thus, since the amount of ionic impurities in extracted water becomes large when unwashed fly ash is used directly as a blending component of a material for semiconductor encapsulation as described in the above, volume resistivity of hardened product of the obtained material for semiconductor encapsulation becomes 1.0 x 10$^{14}$ $\Omega$·cm at 100°C, which is 1/10 or less, so that considerably poor results are obtained by various moisture resistance tests.

The fly ash powder of the present invention is prepared using a fly ash powder material containing a large amount of ionic impurities as described in the above and by purifying this via a specific method. In addition, as the fly ash powder material to be used as the material of the fly ash powder of the present invention, a material having a desired average particle diameter is optionally selected and used in response to its application and the like. The average particle diameter can be measured, for example, using a laser diffraction scattering type particle size distribution measuring device.

Accordingly, the fly ash powder of the present invention contains substantially no silanol group, wherein electric conductivity of water extract after soaking of 10 g of the fly ash powder in 100 ml of pure water at 20°C for 6 hours is 200 $\mu$S/cm or less, and which is preferably purified into such a level that electric conductivity of the water extract becomes 10 $\mu$S/cm or less.

Particularly preferred is a case in which electric conductivity of water extract after soaking of 10 g of the fly ash powder in 100 ml of pure water at 160°C for 24 hours is 50 $\mu$S/cm or less, and which is purified into such a level that it contains substantially no silanol group.

As the aforementioned pure water, for example, industrial water and service water which contain a small amount of ionic impurities, or ion exchange water and ultra-pure water that contains almost no ionic impurities and the like may be cited. Among them, it is particularly desirable to use ion exchange water or ultra-pure water. Illustratively, it is suitable to use a pure water having an electric conductivity of 1 $\mu$S/cm or less.

The fly ash powder of the present invention is produced, for example, by the two kinds of methods shown in the following. One of them is a production method (1) in which a fly ash powder material is baked at a temperature of from 500 to 900°C. Thereafter, the aforementioned fly ash powder material after baking is washed using a diluted acidic aqueous solution having an acid concentration of 1.0 mol/l or less, subsequently washed using pure water, dried and then pulverized.

The other method is a production method (2) in which a fly ash powder material is baked at a temperature of from 500 to 900°C. Thereafter, the aforementioned fly ash powder material after baking is washed using a concentrated acidic aqueous solution having an acid concentration of 15.0 mol/l or more, subsequently washed using pure water, and then dried and pulverized. Subsequently, this is again baked at a temperature of from 500 to 900°C.

As described in the above, the firstly carried out step for baking a fly ash powder within the range of from 500 to 900°C is carried out before the washing steps by an acidic aqueous solution and pure water, and unburned carbon and ammonia on the surface of fly ash powder particles are removed, so that the subsequent washing can be carried out efficiently.

By washing the baked fly ash powder using an acidic aqueous solution after the aforementioned baking step, alkaline components (e.g., calcium) in the fly ash powder are eluted, so that it becomes possible as a result to remove ionic impurities to extremely low level.

The aforementioned acidic aqueous solution is not particularly limited, as long as it can elute alkaline components in the fly ash powder, and its examples include various aqueous solutions such as of hydrochloric acid, sulfuric acid, phosphoric acid and the like. Regarding acid concentration of the acidic aqueous solution, it is desirable to carry out the mixing and stirring treatments in the acidic aqueous solution at such an acid concentration that dispersion of the fly ash powder becomes proper, from the viewpoint of efficient preliminary washing. Also, according to the present invention, two kinds are used as the aforementioned acidic solution by taking the subsequent steps into consideration as described in the foregoing. One is an acidic aqueous solution having an acid concentration of 1.0 mol/l or less, and in describing more illustratively, it is to use a diluted strong acid aqueous solution of 1.0 mol/l or less at 20°C. The lower limit of acid concentration in this case is generally $1.0 \times 10^{-3}$ mol/l. The other one is an acidic aqueous solution of 15.0 mol/l or more, and in describing more illustratively, it is to use a concentrated acidic aqueous solution of 15.0 mol/l or more at 20°C. The upper limit of acid concentration in this case is not particularly limited, but in the case of commercially available concentrated hydrochloric acid, it is generally about 15 mol/l. In addition, when the aforementioned acidic aqueous solution of 15.0 mol/l or more is used, generation of silanol group becomes remarkable, so that it is necessary to carry out final re-baking within the range of from 500°C to 900°C as described in the foregoing. Thus, when an acidic aqueous solution having an acid concentration of 1.0 mol/l or less is used, formation of silanol group is controlled in comparison with the case of the use of an acidic aqueous solution of 15.0 mol/l or more, and as a result, a tendency of somewhat improving dispersibility (wettability) with the epoxy resin which is described later can be seen.

The washing step using pure water, which is carried out after the aforementioned washing step using an acidic aqueous solution, reduces ionic impurities considered to be adhered on the surface of fly ash powder particles, by soaking the fly ash powder of after baking and acidic aqueous solution washing into pure water, preferably carrying out shaking or stirring operation, and thereby efficiently eluting the ionic impurities into the water extract.

The pure water to be used in the aforementioned washing step is not particularly limited, and similar to the aforementioned case, for example, industrial water and service water which contain a small amount of ionic impurities, or ion exchange water and ultra-pure water that hardly contain ionic impurities and the like may be cited. In addition, when further reduction of the amount of ionic impurities is planned corresponding to the intended amount of ionic impurities, it is desirable to use ion exchange water or ultra-pure water in response to the washing degree. Illustratively, it is desirable to use a pure water having an electric conductivity of 1 µS/cm or less.

Further, temperature of pure water in the aforementioned washing step which uses pure water is not particularly limited too, and it may be within the range of from 0 to 100°C. In more illustratively describing, a method in which an extraction washing operation by ordinary temperature water of from 0 to 20°C, a solid-liquid separation operation and a drying operation are continuously repeated about 4 to 5 times, and then an extraction washing operation by high temperature hot water of from 80 to 100°C, a solid-liquid separation operation and a drying operation are also continuously repeated about 4 to 5 times, is desirable because it renders possible economical and efficient reduction of the amount of ionic impurities. In this connection, when the washing is carried out using a high temperature high pressure water of 100°C or more, the ionic impurities can be further reduced, but the apparatus becomes large scale so that the economic performance is considerably reduced.

Also, solid-liquid ratio at the time of mixing and stirring the fly ash powder and pure water in the aforementioned washing step which uses pure water is not particularly limited too, but it is desirable to increase the washing frequency by increasing ratio of the fly ash powder, because reduction of the amount of washing water can be made.

In addition, the mixing stirrer at the time of extraction washing in the aforementioned washing step is not particularly limited, and a general disper-stirrer or the like having superior dispersibility is used. Also, regarding the aforementioned solid-liquid separation method, repeating frequency of the solid-liquid separation operation can be reduced and reduction of the ionic impurities can be attained more economically, when the water content of fly ash cake after the separation is small. The solid-liquid separation method in this case is not particularly limited too, and for example, a method by filtration making use of a filter such as of pressure filtration or the like, a centrifugation method, a decanter separation method which uses difference in specific gravity between fly ash and water such as of standing sedimentation, and the like may be cited.

Next, in the drying step which is carried out after the aforementioned washing step that uses pure water, it is necessary to remove water completely from the fly ash cake, but the drying method is not particularly limited, and, for example, a method in which the fly ash cake after solid-liquid separation is dried and solidified in a high temperature oven, a heat drying solidification method by a spray dryer, and the like may be cited. In this connection, when the fly ash is aggregated at the time of drying, it is desirable to employ a suitably loosening operation.

In addition, when an acidic aqueous solution of 15.0 mol/l or more is used in the aforementioned washing step which uses an acidic aqueous solution, it is necessary to re-bake the fly ash powder pulverized via the aforementioned drying step, under a temperature condition of from 500 to 900°C. Thus, by carrying out the re-baking, amount of silanol group formed on the surface of fly ash powder particles is reduced, and kneading ability, moldability and fluidity become good.

Accordingly, the action and effect obtained by carrying out re-baking under the aforementioned temperature condition can be considered as follows. That is, it is considered that the groups having OH group (e.g., a silanol group) are remarkably formed on the surface of particles of the fly ash powder in the aforementioned washing step which uses a high concentration acidic aqueous solution of 15.0 mol/l or more, and the wettability becomes poor when the washing-treated fly ash powder and a resin component to be mixed and formulated for obtaining a resin composition are not hydrophilic. As an example, the resin components to be used in materials for semiconductor encapsulation are epoxy resin, phenol resin and the like. Since they are basically hydrophobic, the wettability is poor when simply washed with pure water, thus causing poor kneading. As a result, there is a possibility of reducing moldability and fluidity so that it becomes substantially difficult to use them as molding materials. Thus, it is considered that the silanol group as a group having OH group on the fly ash powder surface is reduced by carrying out the aforementioned re-baking, and superior moldability and fluidity are obtained. In this connection, surface treatment with a special silane coupling agent can be considered for removing silanol group. However, since this is an expensive treating method, the inexpensive and convenient re-baking treatment is recommended from the economical point of view.

The fly ash powder obtained in this manner can be applied to the filling materials of various fields, such as electrical insulating materials, fillers of paints, materials for semiconductor encapsulation and the like. As an example, in the materials for semiconductor encapsulation, very expensive spherical fused silica is frequently used from the viewpoint of reliability characteristics and fluidity characteristics. However, since the fly ash powder of the present invention is inexpensive and spherical, it can be used effectively as the inorganic filler for the materials for semiconductor encapsulation.

As an example of the use of the fly ash powder of the present invention, the inorganic filler for the materials for semiconductor encapsulation may be cited as described in the above. Regarding its use embodiment, it is used in the same manner as of the conventional inorganic fillers, and its application method is not particularly limited.

The resin composition for semiconductor encapsulation as an example of the application which uses the fly ash powder of the present invention is not particularly limited. For example, it contains an epoxy resin, a phenol resin, a hardening accelerator and an inorganic filler and is generally in the form of powder or in the form of tablet in which the former is made into a tablet. A part or the entire portion of the aforementioned inorganic filler is replaced by the fly ash powder of the present invention.

The aforementioned epoxy resin, phenol resin, hardening accelerator and inorganic filler are not particularly limited, and those which are conventionally used as the materials for semiconductor encapsulation are optionally used. In addition to the epoxy resin, phenol resin, hardening accelerator and inorganic filler, a conventionally known flame retardant, a flame retardant assisting agent, a release agent, a pigment or coloring agent, a silane coupling agent, a stress lowering agent and the like other additive agents can be optionally added in response to the necessity.

The resin composition for semiconductor encapsulation which uses the fly ash powder of the present invention can be produced, for example, by a series of steps in which the aforementioned respective components are formulated and mixed and then melt-mixed under a heated condition by applying to a kneader such as a mixing roller or the like, this is cooled to room temperature and then pulverized by a conventionally known means, and then this is made into tablets as occasion demands.

The encapsulation of a semiconductor element using such an epoxy resin composition is not particularly limited, and it can be carried out by a conventionally known molding method such as a general transfer molding or the like.

<Examples>

Next, Examples are described together with comparative examples.

As shown below, various fly ash powders were produced.

Examples 1 to 6

[Fly ash powder A]

A 5 kg portion of a fly ash powder material (average particle diameter 2 $\mu$m) was prepared, and this was baked at a temperature of 600°C for 8 hours. Subsequently, this was mixed by stirring for 24 hours in 50 kg of an acidic aqueous solution, i.e., hydrochloric acid aqueous solution having a concentration of about 1.0 mol/l, and then solid-liquid separation was carried out almost completely by a pressure filter filtration operation. The cake-like fly ash on the filter was put into 50 kg of pure water of ordinary temperature and mixed by stirring for about 30 minutes, and then solid-liquid separation thereof was effected almost completely by the same pressure filter filtration operation. This washing operation by ordinary temperature pure water was repeated a total of 10 times, and then the same washing operation was repeated a total of 15 times using ultra-pure water of 90°C. The thus obtained fly ash cake was dried and solidified in a drier of 120°C for 24 hours, and then the aggregates were thoroughly loosened to prepare the fly ash powder A of interest.

[Fly ash powder B]

A fly ash powder material having an average particle diameter of 5 $\mu$m was used. Except for this, a fly ash powder B was prepared in the same manner as in the fly ash powder A.

[Fly ash powder C]

A fly ash powder material having an average particle diameter of 25 $\mu$m was used. Except for this, a fly ash powder C was prepared in the same manner as in the fly ash powder A.

[Fly ash powder D]

A 5 kg portion of a fly ash powder material (average particle diameter 2 $\mu$m) was prepared, and this was baked at a temperature of 600°C for 8 hours. Subsequently, this was mixed by stirring for 24 hours in 50 kg of an acidic aqueous solution, concentrated hydrochloric acid aqueous solution having a concentration of about 15.0 mol/l, and then solid-liquid separation thereof was effected almost completely by a pressure filter filtration operation. The cake-like fly ash on the filter was put into 50 kg of pure water of ordinary temperature and mixed by stirring for about 30 minutes, and then solid-liquid separation thereof was effected almost completely by the same pressure filter filtration operation. This washing operation by ordinary temperature pure water was repeated a total of 10 times, and then the same washing operation was repeated a total of 15 times using ultra-pure water of 90°C. The thus obtained fly ash cake was dried and solidified in a drier of 120°C for 24 hours, and then the aggregates were thoroughly loosened to prepare a fly ash powder. Next, the thus obtained fly ash powder was further baked at a temperature of 600°C for 8 hours to prepare the fly ash powder D of interest.

[Fly ash powder E]

A fly ash powder material having an average particle diameter of 5 $\mu$m was used. Except for this, a fly ash powder E was prepared in the same manner as in the fly ash powder D.

[Fly ash powder F]

A fly ash powder material having an average particle diameter of 25 $\mu$m was used. Except for this, a fly ash powder F was prepared in the same manner as in the fly ash powder D.

Comparative Examples 1 to 6

[Fly ash powder G]

In the preparation of the aforementioned fly ash powder D, the re-baking treatment at a temperature of 600°C for 8 hours was not carried out. Except for this, a fly ash powder G was prepared in the same manner as in the fly ash powder D.

[Fly ash powder H]

In the preparation of the aforementioned fly ash powder E, the re-baking treatment at a temperature of 600°C for 8 hours was not carried out. Except for this, a fly ash powder H was prepared in the same manner as in the fly ash powder E.

[Fly ash powder I]

In the preparation of the aforementioned fly ash powder F, the re-baking treatment at a temperature of 600°C for 8 hours was not carried out. Except for this, a fly ash powder I was prepared in the same manner as in the fly ash powder F.

[Fly ash powder J]

A 5 kg portion of a fly ash powder material (average particle diameter 2 μm) was prepared, and this was baked at a temperature of 600°C for 8 hours to prepare a fly ash powder J.

[Fly ash powder K]

A fly ash powder material having an average particle diameter of 5 μm was used. Except for this, a fly ash powder K was prepared in the same manner as in the fly ash powder J.

[Fly ash powder L]

A fly ash powder material having an average particle diameter of 25 μm was used. Except for this, a fly ash powder L was prepared in the same manner as in the fly ash powder J.

Production steps of each of the thus obtained fly ash powders A to L are shown in Table 1 which is described later, and electric conductivity of water extract in each of the aforementioned fly ash powders A to L was measured in the following manner. That is, 5.0 g of each of the aforementioned fly ash powders was put into a pressure container and soaked in 50 ml of ultra-pure water (electric conductivity, 1 μS/cm or less) at 160°C for 24 hours to obtain a water extract. Thereafter, electric conductivity of this water extract was measured using an electric conductivity meter (mfd. by Horiba, Type DS-15, cell constant 0.1). The results are shown in the following Table 2.

In addition, ratio of the silanol group content in each of the aforementioned fly ash powders A to F was measured in accordance with the aforementioned silanol group content ratio measuring method. The results are also shown in the following Table 2.

Table 1

| | 1st baking treatment of 600°C x 8 hrs | Acid washing treatment by HCl aqueous solution | | Washing treatment by pure water | Rebaking treatment of 600°C x 8 hrs |
| --- | --- | --- | --- | --- | --- |
| | | 1.0 mol/l HCl concentration | 15.0 mol/l HCl concentration | | |
| Fly ash powder A | Yes | Yes | - | Yes | - |
| Fly ash powder B | Yes | Yes | - | Yes | - |
| Fly ash powder C | Yes | Yes | - | Yes | - |
| Fly ash powder D | Yes | - | Yes | Yes | Yes |
| Fly ash powder E | Yes | - | Yes | Yes | Yes |
| Fly ash powder F | Yes | - | Yes | Yes | Yes |
| Fly ash powder G | Yes | - | Yes | Yes | - |
| Fly ash powder H | Yes | - | Yes | Yes | - |
| Fly ash powder I | Yes | - | Yes | Yes | - |
| Fly ash powder J | Yes | - | - | - | - |
| Fly ash powder K | Yes | - | - | - | - |
| Fly ash powder L | Yes | - | - | - | - |

Table 2

| | Average particle diameter (μm) | Electric conductivity (μS/cm) | Ratio of the silanol group content (-) |
|---|---|---|---|
| Fly ash powder A | 2 | 45 | 0.080 |
| Fly ash powder B | 5 | 36 | 0.080 |
| Fly ash powder C | 25 | 15 | 0.080 |
| Fly ash powder D | 2 | 50 | 0.035 |
| Fly ash powder E | 5 | 47 | 0.035 |
| Fly ash powder F | 25 | 31 | 0.035 |
| Fly ash powder G | 2 | 48 | 0.190 |
| Fly ash powder H | 5 | 37 | 0.190 |
| Fly ash powder I | 25 | 20 | 0.190 |
| Fly ash powder J | 2 | 5700 | 0.030 |
| Fly ash powder K | 5 | 5300 | 0.030 |
| Fly ash powder L | 25 | 5420 | 0.030 |

As is evident from the above Table 2, the electric conductivity of water extracts of the fly ash powders J to L obtained by the initial baking treatment alone showed an extremely high value of from 5420 to 5700 μS/cm, while the electric conductivity of water extracts of the fly ash powders A to F obtained via the production steps of the present invention showed a lower value of 50 μS/cm, showing that the ionic impurities were reduced by the series of washing steps. In addition, regarding the ratio of the silanol group content, the ratio of the silanol group content of the fly ash powders G to I which was subjected to the washing step of using 15.0 mol/l of concentrated hydrochloric acid aqueous solution but not subjected to the re-baking treatment was 0.190 showing high residual ratio of silanol group, while the ratio of silanol group was reduced to 0.10 or less, or from 0.035 to 0.080, in the fly ash powders A to F obtained by the production steps of the present invention.

Next, a test was carried out on the change of state of dispersibility due to difference in wettability between a liquid epoxy resin (EP-827, mfd. by YUKA SHELL) and each of the aforementioned fly ash powders A to L. Regarding the test method, 5.0 g of the liquid epoxy resin (EP-827) and 10.0 g of each fly ash powder were put into a beaker, kept at 170°C while heating, and simply stirred and mixed for 5 minutes using a glass rod. State of the mixed slurry thereafter was observed with the naked eye and evaluated. The results are shown in the following Table 3.

Table 3

| | Wettability evaluation of EP-827 and each powder |
|---|---|
| Fly ash powder A | O |
| Fly ash powder B | O |
| Fly ash powder C | O |
| Fly ash powder D | OO |
| Fly ash powder E | OO |
| Fly ash powder F | OO |
| Fly ash powder G | X |
| Fly ash powder H | X |
| Fly ash powder I | X |
| Fly ash powder J | OO |
| Fly ash powder K | OO |

Table continued

| | Wettability evaluation of EP-827 and each powder |
|---|---|
| Fly ash powder L | OO |
| OO: The powder is uniformly dispersed in EP-827 and becomes a glossy creamy form.<br>O: The powder is almost uniformly dispersed in EP-827, to such a degree that some granulated parts are observed.<br>X: The powder is not uniformly dispersed in EP-827, but aggregates and becomes glossless particles. | |

As is evident from the above Table 3, in the case of the samples in which each of the fly ash powders G to I having high ratio of the silanol group content was mixed with the liquid epoxy resin (EP-827) and stirred, the fly ash powder was not uniformly dispersed, but the powder particles became an aggregated state and became glossless particles. Contrary to this, in the case of the fly ash powders A to F having low ratio of the silanol group content, or identical to those which substantially do not contain it, the powder particles were uniformly dispersed and became a glossy creamy form, or almost uniformly dispersed to such a degree that some granulated parts were observed.

Thus, it is clear from the results of the aforementioned Table 2 and Table 3 that wettability for the epoxy resin was improved and dispersibility was improved in Example products having an electric conductivity of 50 μS/cm or less and with reduced silanol group, which were produced by employing a baking step, a washing step using an acidic aqueous solution and a washing step using pure water as the basic steps. In this connection, in the case of the fly ash powders J to L, since they were prepared via only the aforementioned initial baking treatment, the silanol group is small, the powders are uniformly dispersed and their wettability is good, but since they contain ionic impurities in large amounts, the electric conductivity is extremely large so that it is evident that they are unfit for the applications for which high reliability is required in the electric, electronic and the like fields.

Next, epoxy resin compositions for semiconductor encapsulation were prepared as materials for semiconductor encapsulation, using the aforementioned fly ash powders A to F.

Regarding blending components of the aforementioned epoxy resin compositions, 100 weight parts (to be referred to as "part" hereinafter) of a cresol novolak epoxy resin, 15 parts of a brominated epoxy resin, 58 parts of a phenol novolak resin, 2 parts of a hardening accelerator (1,8-diazabicyclo[5,4,0]undecene-7), 2 parts of carbon black, 1 part of a silane coupling agent, 3 parts of carnauba wax and 800 parts in each of the fly ash powders A to F were used. These respective components were formulated and melt-kneaded for 3 minutes using a mixing roller (temperature 100°C). Next, this melted products were cooled and then pulverized to obtain 6 kinds of epoxy resin compositions for semiconductor encapsulation.

Thereafter, a semiconductor element was mounted on a 16 pin dual inline package (16 pin DIP) lead frame to carry out wire bonding, resin-filled by transfer molding using each of the aforementioned epoxy resin compositions, hardened under a condition of 175°C x 120 seconds, and subjected to a post-curing of 175°C x 5 hours, thereby producing respective semiconductor devices.

The semiconductor devices produced in this manner by resin-filling with the epoxy resin compositions for semiconductor encapsulation, prepared using the aforementioned fly ash powders A to F instead of the fused spherical silica powder as a conventional inorganic filler, showed no problems in using them.

<Industrial Applicability>

As described in the foregoing, the present invention is a fly ash powder in which the electric conductivity of water extract after soaking 10 g of the fly ash powder in 100 ml of pure water at 20°C for 6 hours is 200 μS/cm or less, and it contains substantially no silanol group. Because of this, wettability of this powder with a resin composition becomes proper, and as a result, moldability and fluidity become excellent. In addition, such a fly ash powder is produced by baking a fly ash powder material at a temperature of from 500 to 900°C, and then washing the aforementioned fly ash powder material after baking using an acidic aqueous solution having a specified acid concentration, subsequently washing using pure water, and then drying and pulverizing it. Alternatively, when the aforementioned acidic aqueous solution having a high acid concentration is used, this is produced by further re-baking at a temperature of from 500 to 900°C after the aforementioned drying and pulverization. By such a production method, the aforementioned fly ash powder from which ionic impurities are removed to a considerably low containing amount and which contains substantially no silanol group is obtained, and, for example, low cost products having characteristics similar to those of the inorganic fillers (e.g., spherical fused silica and the like) can be obtained.

Accordingly, the fly ash powder of the present invention is useful, for example, as electrical insulating materials, fillers for paints and materials for semiconductor encapsulation. Particularly, when used as materials for semiconductor encapsulation, this can be desirably used as a substitute for the conventionally used expensive spherical fused silica in view of the reliability and fluidity, so that reduction of cost can be realized.

Thus, the resin composition for semiconductor encapsulation which comprises the fly ash powder of the present invention as its inorganic filler is excellent in moldability and fluidity, and semiconductor devices resin-filled therewith, which are equivalent to the conventional counterparts, can be obtained.

While the invention has been describe in detail and with reference to specific embodiments thereof, it will be apparent to one skilled in the art that various changes and modifications can be made therein without departing from the spirit and scope of the invention.

This application is based on a Japanese patent application filed on May 8, 2003 (Japanese Patent Application No. 2003-130367), the entire contents thereof being thereby incorporated by reference.

**Claims**

1. A fly ash powder containing substantially no silanol group, wherein the electric conductivity of water extract after soaking of 10 g of the fly ash powder in 100 ml of a pure water at 20°C for 6 hours is 200 μS/cm or less.

2. The fly ash powder according to claim 1, wherein the electric conductivity of the pure water is 1 μS/cm or less.

3. A method for producing a fly ash powder, which is a method for producing the fly ash powder of claim 1 or 2, which comprises a step of baking a fly ash powder material at a temperature of from 500 to 900°C, a step of washing the fly ash powder material after baking using an acidic aqueous solution having an acid concentration of 1.0 mol/l or less, a step of subsequently washing the same using a pure water, and a step of drying and pulverizing the same.

4. A method for producing a fly ash powder, which is a method for producing the fly ash powder of claim 1 or 2, which comprises a step of baking a fly ash powder material at a temperature of from 500 to 900°C, a step of washing the fly ash powder material after baking using an acidic aqueous solution having an acid concentration of 15.0 mol/l or less, a step of subsequently washing the same using a pure water, a step of drying and pulverizing the same, and a step of again baking the same at a temperature of from 500 to 900°C.

5. The method for producing a fly ash powder of claim 3 or 4, wherein said washing step using a pure water comprises repeated steps of water washing with a pure water having an electric conductivity of 1 μS/cm or less at from 0 to 100°C, filtration and drying.

6. A resin composition for semiconductor encapsulation, which comprises a resin, and the fly ash powder according to claim 1 or 2 as an inorganic filler.

7. The resin composition for semiconductor encapsulation according to claim 6, wherein ratio of the fly ash powder occupying inorganic fillers in the resin composition for semiconductor encapsulation is from 10 to 100% by weight based on the total weight of inorganic fillers.

8. A semiconductor device comprising a semiconductor element having been encapsulated with the resin composition for semiconductor encapsulation according to claim 6 or 7.

## INTERNATIONAL SEARCH REPORT

| International application No. |
|---|
| PCT/JP2004/003175 |

| A. CLASSIFICATION OF SUBJECT MATTER |
|---|
| Int.Cl⁷  B09B3/00, C01B33/18, C08K3/36, C08L101/00, H01L23/30 |

According to International Patent Classification (IPC) or to both national classification and IPC

| B. FIELDS SEARCHED |
|---|
| Minimum documentation searched (classification system followed by classification symbols)<br>Int.Cl⁷  B09B3/00-5/00, C01B33/12-18, C08K3/34-36, C08L101/00, H01L23/30 |

Documentation searched other than minimum documentation to the extent that such documents are included in the fields searched
Jitsuyo Shinan Koho          1926-1996    Toroku Jitsuyo Shinan Koho    1994-2004
Kokai Jitsuyo Shinan Koho    1971-2004    Jitsuyo Shinan Toroku Koho    1996-2004

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y<br>A | JP 2003-47930 A  (Shikoku Research Institute Inc.);<br>18 February, 2003 (18.02.03),<br>Par. Nos. [0010] to [0019]<br>(Family: none) | 1-3,5-8<br>4. |
| Y<br>A | JP 11-199218 A  (Kabushiki Kaisha Tatsumori),<br>27 July, 1999 (27.07.99),<br>Par. Nos. [0005] to [0017]<br>(Family: none) | 1-3,5-8<br>4 |
| A | JP 11-43320 A  (Toshiba Ceramics Co., Ltd.),<br>16 February, 1999 (16.02.99),<br>Par. Nos. [0018] to [0026]<br>(Family: none) | 1-8 |

☐ Further documents are listed in the continuation of Box C.   ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>11 June, 2004 (11.06.04) | Date of mailing of the international search report<br>29 June, 2004 (29.06.04) |
|---|---|
| Name and mailing address of the ISA/<br>Japanese Patent Office | Authorized officer |
| Facsimile No. | Telephone No. |

Form PCT/ISA/210 (second sheet) (January 2004)